# EUROPÄISCHE PATENTSCHRIFT

(11) **EP 1 722 420 B1**
(45) Veröffentlichungstag und Bekanntmachung des Hinweises auf die Patenterteilung: **23.04.2008**
(21) Anmeldenummer: 06002404.9
(22) Anmeldetag: 07.02.2006
(51) Int. Cl.: H01L 27/146

(54) **Optoelekrtonische Anordnung und Verfahren zu deren Herstellung**
Optoelectronic device and production method
Dispositif électronique et procédé de fabrication

(30) Priorität: 09.05.2005 DE 102005021991
(43) Veröffentlichungstag der Anmeldung: 15.11.2006
(73) Patentinhaber: Dr. Johannes Heidenhain GmbH, 83292 Traunreut (DE)
(72) Erfinder: Rissing, Lutz, 83209 Prien (DE); Siglbauer, Dietmar, 83379 Wonneberg (DE)

(56) Entgegenhaltungen:
- EP-A- 0 303 808
- WO-A-00/07052
- DE-A1- 10 021 367

## Beschreibung

Die Erfindung betrifft eine optoelektronische Anordnung gemäß dem Patentanspruch 1, sowie ein Verfahren zu deren Herstellung gemäß dem Patentanspruch 8.

Optoelektronische Anordnungen, werden beispielsweise zur Erfassung von moduliertem Licht in optisch wirkenden Positionsmessgeräten verwendet. Dabei beinhaltet das Licht Positionsinformationen. Nach Umwandlung des Lichtes in elektrische Signale mit Hilfe von optoelektronischen Elementen, wie etwa Fotoelementen, können die Positionsinformationen elektronisch weiterverarbeitet und ausgewertet werden.

Als Fotoelemente werden häufig Halbleiter-Bauteile, insbesondere Silizium-Bauteile, verwendet, die auf einer Leiterplatte montiert sind. Oft ist zudem die Unterseite des Fotoelements elektrisch leitend an einem Pad der Leiterplatte befestigt und die strahlungsempfindliche Fläche, die meist der Leiterplatte abgewandt ist, wird dann durch eine Wire-Bond-Verbindung mit einer Leiterbahn der Leiterplatte verbunden. Zwischen Wire-Bond-Verbindung und dem Pad an der Unterseite des Fotoelements liegen dann die Signale an.

Nicht selten werden aber auch die Fotoelemente, z. B. CMOS-Bausteine, nur zur mechanischen Befestigung mit einem Pad der Leiterplatte verlötet, ohne dass Signale von diesem Pad abgeleitet werden. In diesem Fall werden dann meistens zwei oder mehr Wire-Bond-Verbindungen vom Fotoelement zur Leiterplatte geführt, über die dann die Signale geleitet werden.

In der DE 101 18 231 A1 der Anmelderin ist eine entsprechende optoelektronische Anordnung gezeigt. Diese optoelektronische Anordnung hat den Nachteil, dass bei deren Herstellung nicht vernachlässigbare Ausschussraten festzustellen sind.

In der WO 00/07052 A1 der Anmelderin ist eine optoelektronische Sende- und Empfangseinheit beschrieben, bei der Kontaktierungselemente über die Oberfläche eines Trägerelements im Bereich der Ränder der Sende- und Empfangseinheit verteilt angeordnet sind.

Der Erfindung liegt die Aufgabe zugrunde, eine optoelektronischeAnordnung der eingangs genannten Art zu schaffen, die qualitativ hochwertig und überaus wirtschaftlich herstellbar ist. Entsprechend soll weiterhin ein verbessertes Verfahren zur Herstellung von optoelektronische Anordnungen geschaffen Werden.

Diese Aufgabe wird erfindungsgemäß durch die Schaffung einer optoelektronische Anordnung mit den Merkmalen des Patentanspruchs 1 gelöst. Im Anspruch 7 wird ein Verfahren zur Herstellung einer derartigen optoelektronische Anordnung angegeben

Demnach besteht die optoelektronische Anordnung aus einer Leiterplatte mit einem Ground-Pad und einem Bond-Pad, sowie einem optoelektronischen Element. Das optoelektronische Element ist zumindest über einen Bond-Draht mit dem Bond-Pad elektrisch kontaktiert und mittels einer Lötverbindung an dem Ground-Pad befestigt. Das Ground-Pad ist so ausgestaltet dass ein Teil des Zwischenraumes zwischen der Leiterplatte und dem optoelektronischen Element nicht mit Lot ausgefüllt ist. Demnach ist also der Zwischenraum zwischen der Leiterplatte und dem optoelektronischen Element nur teilweise bzw. unvollständig mit Lot ausgefüllt. Das Ground-Pad kann im Übrigen auch als Anschluss-Pad bezeichnet werden

Es hat sich überraschenderweise gezeigt, dass sich mit einer derartigen Anordnung die Ausschussraten bei der Herstellung der optoelektronischen Anordnung erheblich reduzieren lassen.

Die Positionen der optoelektronischen Elemente werden üblicherweise nach dem Verlöten mit dem Ground-Pad und vor dem Wire-Bonden mit Hilfe einer Kamera optisch inspiziert bzw. ermittelt. Bei herkömmlich gestalteten Ground-Pads verlief diese optische Inspektion immer wieder fehlerhaft. Dies hatte zur Folge, dass die Kontaktierung mit dem Bond-Draht an falscher Stelle auf dem optoelektronischen Element durchgeführt wurde, wodurch die entsprechend hergestellte optoelektronische Anordnung unbrauchbar war.

Als optoelektronische Elemente sind beispielsweise Fotoelemente zu verstehen, durch welche Licht in elektrische Signale umwandelbar ist. Dies können auch so genannte optische Chips bzw. optische ASICs sein, die zusätzlich zu den fotoempfindlichen Bereichen auch integrierte elektrische Schaltungen aufweisen. Die optoelektronische Anordnung ist dann als Fotodetektoranordnung ausgestaltet. Ferner sind im Zusammenhang mit der Erfindung unter optoelektronischen Elementen auch Licht emittierende bzw. Licht erzeugende Bauteile zu verstehen, die in der Regel glatte reflektierende Oberflächen aufweisen, um das erzeugte Licht optimal abzustrahlen. Allen optoelektronischen Elementen im Sinn der Erfindung ist gemein, dass diese eine überaus stark reflektierende Oberfläche aufweisen.

Es wurde herausgefunden, dass die Ursache für eine fehlerhafte optische Inspektion darin liegt, dass die überaus glatte und reflektierende Oberfläche des optoelektronischen Elements gelegentlich nicht mit ausreichender Parallelität zur Leiterplatte montiert wurde. Daraus ergibt sich, dass durch Reflexionseffekte die optische Inspektion bzw. die optische Positionserfassung der optoelektronischen Elemente gestört wird. Durch die erfindungsgemäße Anordnung ist es nunmehr erheblich einfacher, eine planparallele Ausrichtung des optoelektronischen Elements zur Leiterplatte zu gewährleisten. Weiterhin können uneinheitlich schräg liegende optoelektronische Elemente unabhängig von dem Problem der Positionserfassung die Qualität der Wire-Bond-Verbindungen negativ beeinflussen.

Die Erfindung umfasst sowohl optoelektronische Anordnungen, bei denen die Lötverbindung zwischen Ground-Pad und Leiterplatte zur elektrischen Anbindung des optoelektronischen Elements dient, als auch optoelektronische Anordnungen, bei denen die besagte Lötverbindung lediglich zur mechanischen Befestigung des optoelektronischen Elements an der Leiterplatte verwendet wird.

Mit Vorteil ist die optoelektronische Anordnung derart ausgestaltet, dass der Zwischenraum am Rand der Fläche des optoelektronischen Elements, welche der Leiterplatte zugewandt ist, größtenteils mit Lot ausgefüllt ist.

Dadurch wird eine hervorragende Planparallelität zur Leiterplatte, also eine parallele Ausrichtung in zwei Dimensionen, erreicht.

Zu dem gleichen Zweck liegen mit Vorteil die längeren Seiten des optoelektronischen Elements parallel zu den Schenkeln des H-förmigen Ground-Pads, wobei das optoelektronische Element eine rechteckige Grundfläche aufweist.

Zusätzliche vorteilhafte Ausgestaltungen der Erfindung sind den abhängigen Ansprüchen zu entnehmen.

Weitere Merkmale und Vorteile der Erfindung werden bei der nachfolgenden Beschreibung eines Ausführurigsbeispiels anhand der Figuren deutlich werden.

Es zeigen die:
- Figur 1: eine Draufsicht auf einen Ausschnitt einer Leiterplatte der optoelektronischen Anordnung ohne Fotoelement,
- Figur 2: eine Draufsicht auf einen Ausschnitt einer Leiterplatte der optoelektronischen Anordnung ohne Fotoelement mit aufgetragener Lotpaste,
- Figur 3: eine Draufsicht auf einen Ausschnitt einer Leiterplatte der optoelektronischen Anordnung mit Fotoelement,
- Figur 4: einen Schnitt A- A durch die Leiterplatte der optoelektronischen Anordnung,
- Figur 5: einen Schnitt B-B durch die Leiterplatte der optoelektronischen Anordnung,
- Figur 6: einen Schnitt durch die Leiterplatte der optoelektronischen Anordnung gemäß einem weiteren Ausführungsbeispiel.

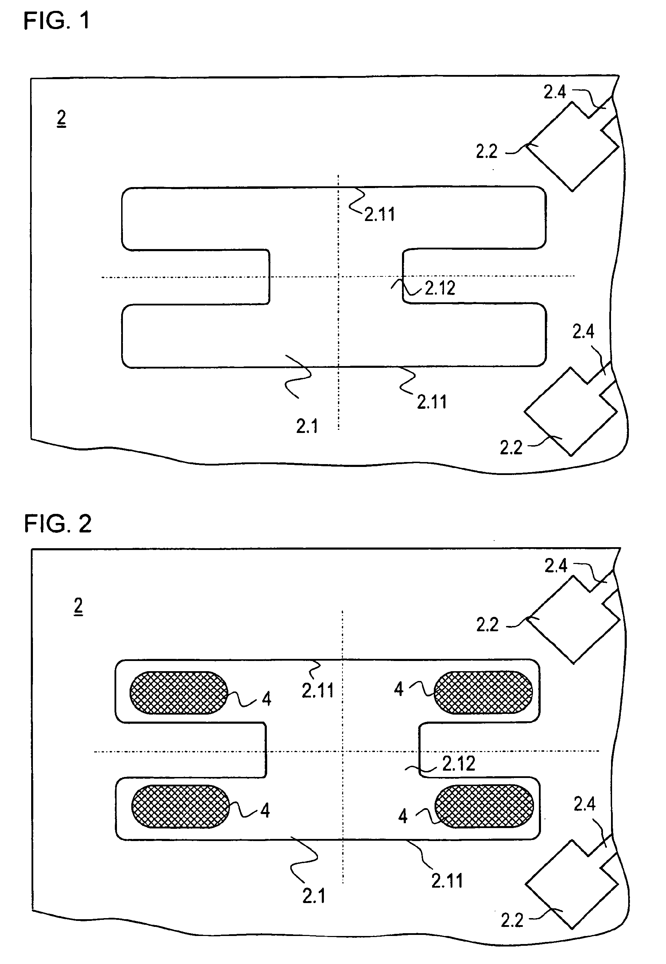

In der Figur 1 ist ein kleiner Ausschnitt einer Leiterplatte 2 in einer Draufsicht gezeigt. Die Leiterplatte 2 weist eine Vielzahl von Lötpads auf, wobei im gezeigten Ausschnitt der Übersichtlichkeit halber nur ein Ground-Pad 2.1 und zwei Bond-Pads 2.2 dargestellt sind. Das Ground-Pad 2.1, das im vorgestellten Beispiel aus Kupfer mit Metallisierung besteht, ist H-förmig ausgestaltet und ist somit bezüglich jeder der beiden gestrichelten Achsen in den Figuren 1 bis 3 symmetrisch, bzw. punktsymmetrisch bezüglich des Schnittpunkts der dargestellten Achsen. Entsprechend der H-förmigen Ausgestaltung weist des Ground-Pad 2.1 zwei parallele Schenkel 2.11 auf. Ein Steg 2.12 verbindet die beiden Schenkel 2.11

Ferner umfasst die Leiterplatte 2 Leiterbahnen 2.4, die jeweils mit den Bond-Pads 2.2 verbunden sind. Üblicherweise befinden sich auf einer derartigen Leiterplatte 2 eine Vielzahl von Ground-Pads 2.1, Bond-Pads 2.2 und den dazugehörigen Leiterbahnen 2.4, die nach vorgegeben Muster auf der Leiterplatte 2 angeordnet sind.

Auf eine so konfigurierte Leiterplatte 2 wird in einem ersten Herstellungsschritt, gemäß der Figur 2, Lotpaste 4 mit einem Siebdruckverfahren auf das Ground-Pad 2.1 aufgetragen, wobei die Lotpaste 4 im gezeigten Ausführungsbeispiel nicht in Form eines großen Tropfens aufbracht wird. Vielmehr wird hier die Lotpaste 4 auf mehrere Tropfen, bzw. separate Depots (hier: vier Depots) auf der Oberfläche des Ground-Pads 2.1 verteilt.

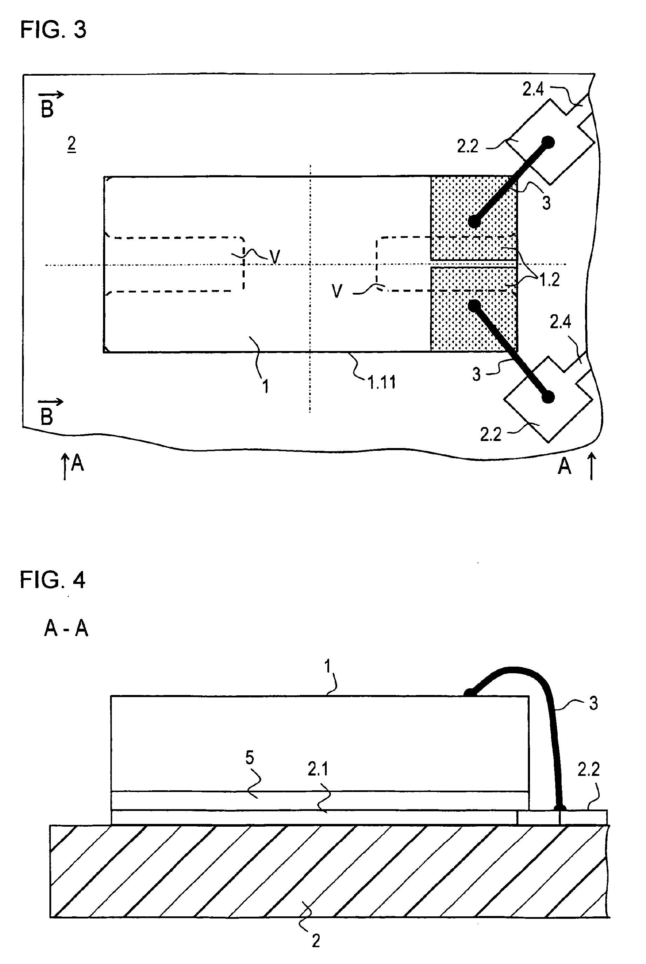

Danach wird als optoelektronisches Element ein rechteckiges Fotoelement 1 gemäß der Figur 3 auf die Depots der Lotpaste 4 aufgesetzt, bzw. auf dem Ground-Pad 2.1 platziert. Es hat sich gezeigt, dass es besonders vorteilhaft ist, wenn, wie hier beschrieben, das Fotoelement 1 auf mehreren vergleichsweise kleinen Bereichen (Depots) auf der Lotpaste 4 aufliegt, weil dann bereits in dieser Herstellungsphase eine planparallele Ausrichtung des Fotoelements 1 bezüglich der Leiterplatte 2 reproduzierbar erreicht wird. Das Aufsetzen wird derart vorgenommen, dass die längeren Seiten 1.11 des Fotoelements 1 parallel zu den Schenkeln 2.11 des H-förmigen Ground-Pads 2.1 zu liegen kommen.

Als Fotoelement 1 kommt im gezeigten Ausführungsbeispiel ein ungehäustes Bauelement in Form eines Halbleiterquaders, z. B. aus Silizium, insbesondere ein CMOS-Baustein, mit rechteckiger Grundfläche (hier 1 mm x 2,6 mm) zum Einsatz. Diejenige Fläche, welche auf der Lotpaste 4 aufliegt, ist ganzflächig metallisiert. Die aktive, im späteren Betrieb bestrahlte Oberfläche ist silbrig glänzend und überaus glatt und reflektiert Licht daher in hohem Maße. Zwei Bereiche der Oberfläche des Fotoelements 1 sind als Bondschicht 1.2 ausgerührt.

Nachdem das Fotoelement 1 auf dem Ground-Pad 2.1 platziert ist, wird die Leiterplatte 2 mit den Fotoelementen 1 in einem Ofen erwärmt, bis die Lotpaste 4 schmilzt. Die flüssige Lotpaste 4 benetzt dabei nur die Fläche des Ground-Pads 2.1, nicht aber die übrige Fläche der Leiterplatte 2. Weiterhin wird die metallisierte Fläche des Fotoelements 1 von der flüssigen Lotpaste 4 benetzt. In welchem Umfang und mit welcher Dicke diese Fläche benetzt wird, hängt davon ab, wie viel Lotpaste 4 aufgetragen wurde. Naturgemäß unterliegt die Menge an aufgetragener Lotpaste 4 gewissen Toleranzen. Durch die ganzflächige Metallisierung des Fotoelements 1 können diese Toleranzen egalisiert werden, weil je nach Menge der Lotpaste 4 die Benetzung der Flächenanteile, die nicht direkt über dem Ground-Pad 2.1 liegen, ausgleichend schwanken wird. Bei mehr Lotpaste 4 wird entsprechend mehr an Fläche des Fotoelements 1 (und ggf. diese in größerer Dicke) benetzt, und zwar in einem Bereich, der nicht über dem Ground-Pad 2.1 liegt, so dass der Abstand zwischen Leiterplatte 2 und Fotoelement 1 von der Ist-Menge an Lotpaste 4 weitgehend unabhängig ist.

Dadurch, dass die Lotpaste 4 auf mehrere Depots aufgeteilt ist, die vergleichsweise weit voneinander beabstandet sind, fließt die flüssige Lotpaste 4 der einzelnen Depots über große Bereiche der Oberfläche des Ground-Pads 2.1 bevor sie sich zu einem Flüssigkeitsvolumen vereinigt. Dies hat den Vorteil, dass in jedem Stadium des Aufschmelzens der Lotpaste 4 eine gleichmäßige Dicke von flüssiger Lotpaste 4 unter dem Fotoelement 1 vorliegt, wodurch ein Verkippen des Fotoelements 1 auch in dieser Phase wirksam vermieden wird (niedriger Meniskus). Das Fotoelement 1 schwimmt also dann auf der Lotpaste 4 auf. Dadurch, dass das Ground-Pad 2.1 H-förmig ausgestaltet ist, wird ein Teil V des Zwischenraums zwischen der Leiterplatte 2 und dem Fotoelement 1 nicht mit flüssiger Lotpaste 4 ausgefüllt. Durch die erfindungsgemäße Gestaltung des Ground-Pads 2.1 bleibt das Fotoelement 1 planparallel zur Leiterplatte 2 ausgerichtet.

Hinzu kommt, dass durch die Geometrie des Ground-Pads 2.1 auch eine Zentrierung und eine richtige Drehwinkelorientierung (Gerade-Zieh-Effekt) des Fotoelements 1 relativ zum Ground-Pad 2.1 erreicht wird. Denn bedingt durch Oberflächenspannungseffekte wird das auf der flüssigen Lotpaste 4 schwimmende Fotoelement 1 stets eine Position anstreben bei der die langen Ränder des Fotoelements 1 genau parallel zu den Schenkeln 2.11 des Ground-Pads 2.1 ausgerichtet sind. Darüber hinaus wird das Fotoelement 1 eine Position einnehmen, in der dessen Ränder exakt über den Außenrändern des Ground-Pads 2.1 liegen, um die Oberflächenenergie zu minimieren. Die Randbereiche des hohlen Teils V des Zwischenraums sind symmetrisch ausgestaltet, so dass sich die Oberflächenkräfte in diesem Teil V kompensieren und nicht die selbständige Ausrichtung und Orientierung des Fotoelements 1 bezüglich des Ground-Pads 2.1 auf der flüssigen Lotpaste 4 stören.

Die vorbekannten Anordnungen waren mit möglichst großen Ground-Pads ausgestattet, weil man bisher davon ausging, dass dadurch die Befestigungs- bzw. Kontaktierungsqualität maximal sei. Bei der Verwendung von herkömmlichen, großflächig gestalteten Ground-Pads kam es jedoch nicht selten vor, dass das entsprechende Fotoelement verkippt wurde, weil die flüssige Lotpaste 4 einen überaus hohen etwa halbkugelförmigen Meniskus bildete.

Nach dem Aufschmelzen der Lotpaste 4 wird die gesamte Anordnung wieder abgekühlt, so dass sich die verflüssigte Lotpaste 4 zu festem Lot 5 umwandelt. Dabei wird das Fotoelement 1 am Ground-Pad 2.1 bzw. an der Leiterplatte 2 mechanisch befestigt. Das Fotoelement 1 liegt auch nach dem Abkühlen planparallel zur Leiterplatte 2. Dies wird dadurch erreicht, dass das Ground-Pad 2.1 so ausgestaltet ist, dass der Teil V des Zwischenraumes zwischen der Leiterplatte 2 und dem Fotoelement 1 nicht mit nunmehr festem Lot 5 ausgefüllt ist. Besonders vorteilhaft ist in diesem Zusammenhang die H-förmige Ausgestaltung des Ground-Pads 2.1. Denn das Fotoelement 1 liegt dann in seinem Randbereich im Wesentlichen entlang der längeren Seiten auf dem Lot 5 auf, so dass Verkippungen minimiert sind. Es ist also der Zwischenraum am Rand der Fläche des Fotoelements 1, welche der Leiterplatte 2 zugewandt ist, größtenteils mit Lot 5 ausgefüllt. Lediglich an seinen kurzen Seiten ist das Fotoelement 1 in den Mittelteilen der Randbereiche nicht verlötet. Der Teil V des Zwischenraumes, der nicht mit dem festen Lot 5 ausgefüllt ist, befindet sich im Wesentlichen nicht an den Rändern des Fotoelements 1. Im gezeigten Ausführungsbeispiel sind nur etwa 10 % der Umfangslinie bzw. des Randes nicht mit Lot 5 benetzt.

Im nächsten Schritt werden die Vorbereitungen für das Wire-Bonden getroffen. In diesem Zusammenhang wird zunächst die Leiterplatte 2 planparallel zu einer optischen Inspektionskamera in eine Fertigungsvorrichtung eingelegt, um die genaue Position der Fotoelemente 1 zu ermitteln. Durch die Planparallelität eines jeden Fotoelements 1 zur Leiterplatte 2 ist somit eine korrekte und einheitliche Orientierung der Oberflächen aller Fotoelemente 1 bezüglich der Inspektionskamera gegeben. Für die Positionsbestimmung ist es wichtig, dass die Messung nicht durch schräg abgestrahlte Reflexionsstrahlen der Fotoelemente 1 verfälscht wird. Durch die Planparallelität der Fotoelemente 1 zur Leiterplatte 2 werden besagte Messverfälschungen vermieden und die Lage des jeweiligen Fotoelements 1 kann schnell und exakt ermittelt werden.

Wenn nun die genaue Position des Fotoelements 1 bekannt ist, können im Zuge des Wire-Bondens Bonddrähte 3 präzise jeweils an der vorgesehenen Stelle am Fotoelement 1, insbesondere auf der Bondschicht 1.2, kontaktiert werden. Ebenso ist eine punktgenaue Kontaktierung der Bond-Drähte 3 an den Bond-Pads 2.2 möglich.

Es wird also vor dem Kontaktieren des Fotoelements 1 über einen Bond-Draht 3 mit dem Bond-Pad 2.2 eine optische Ermittlung der Position des Fotoelements 1 vorgenommen, u. a. zur exakten Positionierung des Bond-Drahts 3 auf dem Fotoelement 1 bzw. auf dessen Bondschicht 1.2.

Nachdem das Fotoelement 1 über die Bond-Drähte 3 mit den Bond-Pads 2.2 kontaktiert ist und mittels der Lötverbindung an dem Ground-Pad 2.1 befestigt ist, wird es mit einer transparenten Vergussmasse vergossen. Dabei werden die Bond-Drähte 3 zum Schutz gegen äußere Einflüsse ebenfalls von der Vergussmasse umschlossen.

Sobald bei der so hergestellten optoelektronischen Anordnung, insbesondere handelt es sich im gezeigten Ausführungsbeispiel um eine Fotodetektoranordnung, Licht auf die Oberfläche des Fotoelements 1 einfällt, wird dieses in elektrische Signale umgewandelt, welche an den beiden Bond-Pads 2.2 abgegriffen werden können.

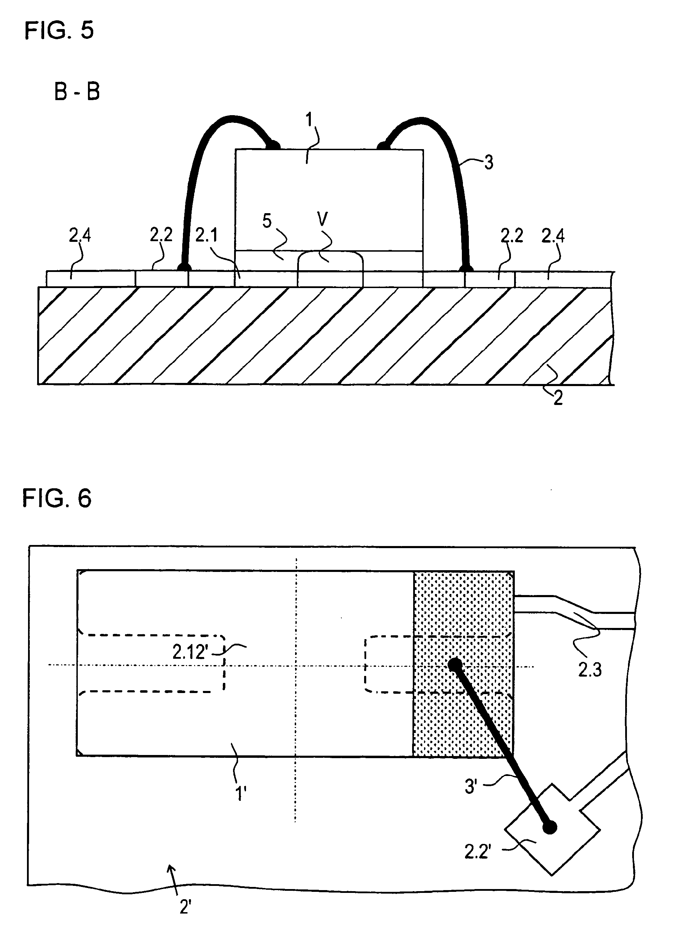

In einer weiteren Abwandlung der Erfindung wird gemäß der Figur 6, ein Fotoelement 1' verwendet, bei dem die elektrischen Signale über nur einen Bond-Draht 3' und über das Ground-Pad 2.1' zur Leiterplatte 2' übertragen werden. Am Ground-Pad 2.1' endet eine Leiterbahn 2.3, welche hier ebenfalls aus Kupfer mit Metallisierung besteht, und über die die elektrischen Signale geleitet werden. In diesem Fall dient also das Ground-Pad 2.1' nicht nur zur planparallelen mechanischen Befestigung des Fotoelements 1' sondern zusätzlich auch zu dessen elektrischer Kontaktierung. Die elektrischen Signale können dann am Ground-Pad 2.1', bzw. an der Leiterbahn 2.3, und am Bond-Pad 2.2' abgegriffen werden.

In einer weiteren alternativen Ausgestaltung der Erfindung kann das Ground-Pad 2.1' durch die Leiterplatte 2' hindurch mit einer Durchkontaktierung versehen sein, so dass auf die Leiterbahn 2.3 verzichtet werden kann. Die Durchkontaktierung trifft das Ground-Pad 2.1' im Bereich des Steges 2.12', dessen Fläche entsprechend dimensioniert ist. Folglich können in diesem Fall die elektrischen Signale am Ground-Pad 2.1', bzw. an der Durchkontaktierung, und am Bond-Pad 2.2' abgegriffen werden.

Die Fotodetektoranordnung, kann in ein optisches Positionsmessgerät eingebaut werden. Dabei wird die Leiterplatte 2, 2' an eine Fläche des entsprechenden Positionsmessgerätes positionsgenau montiert. Durch die erreichte planparallele Ausrichtung der Fotoelemente 1, 1' zur Leiterplatte 2, 2' ist dann auch automatisch gewährleistet, dass das zu detektierende Licht auf jedes einzelne der Fotoelemente 1, 1' im vorgesehenen Einfallswinkel trifft, was letztlich die Funktionsweise des Positionsmessgerätes verbessert.

## Patentansprüche

1. Optoelektronische Anordnung, bestehend aus
- einer Leiterplatte (2, 2') mit einem Ground-Pad (2.1, 2.1') und einem Bond-Pad (2.2, 2.2')
- einem optoelektronischen Element (1, 1'), wobei
das optoelektronische Element (1, 1') über einen Bond-Draht (3, 3') mit dem Bond-Pad (2.2, 2.2') elektrisch kontaktiert ist und mittels einer Lötverbindung am Ground-Pad (2.1, 2.1') befestigt ist, wobei das Ground-Pad (2.1, 2.1') so ausgestaltet ist, dass ein Teil (V) des Zwischenraumes zwischen der Leiterplatte (2, 2') und dem optoelektronischen Element (1, 1') nicht mit Lot (5) ausgefüllt ist,
**dadurch gekennzeichnet, dass** das Ground-Pad (2.1, 2.1') symmetrisch, H-förmig ausgestaltet ist

2. Optoelektronische Anordnung gemäß dem Anspruch 1, **dadurch gekenrtzeichnet, dass** das optoelektronische Element (1, 1') ein Fotoelement ist, durch welches Licht in elektrische Signale umwandelbar ist.

3. Optoelektronische Anordnung gemäß dem Anspruch 1 oder 2, **dadurch gekennzeichnet, dass** der Zwischenraum am Rand der Fläche des optoelektronischen Elements (1, 1'), welche der Leiterplatte (2, 2') zugewandt ist, größtenteils mit Lot (5) ausgefüllt ist.

4. Optoelektronische Anordnung gemäß einem der vorhergehenden Ansprüche, **dadurch gekennzeichnet, dass** das optoelektronische Element (1, 1') eine rechteckige Grundfläche aufweist und dass die längeren Seiten (1.11) der rechteckigen Grundfläche des optoelektronischen Elements (1, 1') parallel zu den Schenkeln (2.11) des H-förmigen Ground-Pads (2.1, 2.1') liegen.

5. Optoelektronische Anordnung gemäß dem Anspruch 2, **dadurch gekennzeichnet, dass** das Fotoelement mit dem Ground-Pad (2.1, 2.1') mittels der Lötverbindung elektrisch leitend befestigt ist und dass eine Leiterbahn 2.3 am Grbund-Pad 2.1 endet, zur Ableitung der elektrischen Signale.

6. Optoelektronische Anordnung gemäß dem Anspruch 2, **dadurch gekennzeichnet, dass** das das Fotoelement mit dem Ground-Pad (2.1, 2.1') mittels der Lötverbindung elektrisch leitend befestigt ist und dass eine Durchkontaktierung am Ground-Pad 2.1 endet, zur Ableitung der elektrischen Signale.

7. Verfahren zur Herstellung einer optoelektronischen Anordnung mit folgenden Schritten:
- Bereitstellen einer Leiterplatte (2, 2') mit einem Ground-Pad (2.1, 2.1') und einem Bond-Pad (2.2, 2.2'), wobei das Ground-Pad (2.1, 2.1') symmetrisch, H-förmig ausgestaltet ist,
- Aufbringen von Lotpaste (4) auf das Ground-Pad (2.1, 2.1'),
- Platzieren eines optoelektronischen Elements (1, 1'), auf dem Ground-Pad (2.1, 2.1'),
- Aufschmelzen der Lotpaste (4) und nachfolgendes Abkühlen, so dass das optoelektronische Element (1, 1') mittels einer Lötverbindung an dem Ground-Pad (2.1, 2.1') befestigt ist, wobei das Ground-Pad (2.1, 2.1') so ausgestaltet ist, dass ein Teil (V) des Zwischenraumes zwischen der Leiterplatte (2, 2') und dem optoelektronischen Element (1, 1') nicht mit Lot (5) ausgefüllt ist, und
- Kontaktieren des Optoelektronischen Elements (1, 1') über einen Bond-Draht (3, 3') mit dem Bond-Pad (2.2, 2.2')

8. Verfahren zur Herstellung einer optoelektronischen Anordnung gemäß dem Anspruch 8, wobei das optoelektronische Element (1, 1') ein Fotoelement ist, durch welches Licht in elektrische Signale umwandelbar ist.

9. Verfahren zur Herstellung einer optoelektronischen Anordnung gemäß dem Anspruch 8 oder 9, wobei vor dem Kontaktieren des optoelektronischen Elements (1, 1') über einen Bond-Draht (3, 3') mit dem Bond-Pad (2.2, 2.2') eine optische Ermittlung der Position des optoelektronischen Elements (1, 1') vorgenommen wird, zur exakten Positionierung des Bond-Drahts (3, 3').

10. Verfahren zur Herstellung einer optoelektronische Anordnung gemäß dem Anspruch 8, 9 oder 10, wobei die Lotpaste (4) derart aufgetragen wird, dass diese auf mehrere Depots auf der Oberfläche des Ground-Pads (2:1, 2.1') verteilt ist.

## Claims

1. Optoelectronic arrangement, comprising
- a printed circuit board (2, 2') with a ground pad (2.1, 2.1') and a bond pad (2.2, 2.2'),
- an optoelectronic element (1, 1'),
the optoelectronic element (1, 1') being electrically contacted to the bond pad (2.2, 2.2') via a bonding wire (3, 3') and attached to the ground pad (2.1, 2.1') by means of a solder connection, the ground pad (2.1, 2.1') being configured such that a part (V) of the intermediate space between the printed circuit board (2, 2') and the optoelectronic element (1, 1') is not filled with solder (5),
**characterised in that** the ground pad (2.1, 2.1') has a symmetrically H-shaped configuration.

2. Optoelectronic arrangement according to claim 1, **characterised in that** the optoelectronic element (1, 1') is a photoelement, by means of which light can be converted into electrical signals.

3. Optoelectronic arrangement according to claim 1 or 2, **characterised in that** the intermediate space at the edge of the surface of the optoelectronic element (1, 1') which is orientated towards the printed circuit board (2, 2') is for the most part filled with solder (5).

4. Optoelectronic arrangement according to one of the preceding claims, **characterised in that** the optoelectronic element (1, 1') has a rectangular base, and **in that** the longer sides (1.11) of the rectangular base of the optoelectronic element (1, 1') are situated parallel to the legs (2.11) of the H-shaped ground pad (2.1, 2.1').

5. Optoelectronic arrangement according to claim 2, **characterised in that** the photoelement is attached electrically conductively to the ground pad (2.1, 2.1') by means of the solder connection, and **in that** a strip conductor (2.3) ends at the ground pad (2.1) in order to conduct the electrical signals.

6. Optoelectronic arrangement according to claim 2, **characterised in that** the photoelement is attached electrically conductively to the ground pad (2.1, 2.1') by means of the solder connection, and **in that** a through-contacting ends at the ground pad (2.1) in order to conduct the electrical signals.

7. Method for the production of an optoelectronic arrangement having the following steps:
- provision of a printed circuit board (2, 2') with a ground pad (2.1, 2.1') and a bond pad (2.2, 2.2'), the ground pad (2.1, 2.1') having a symmetrically H-shaped configuration,
- application of solder paste (4) to the ground pad (2.1, 2.1'),
- placing of an optoelectronic element (1, 1') on the ground pad (2.1, 2.1'),
- melting of the solder paste (4) and subsequent cooling, so that the optoelectronic element (1, 1') is attached to the ground pad (2.1, 2.1') by means of a solder connection, the ground pad (2.1, 2.1') being configured such that a part (V) of the intermediate space between the printed circuit board (2, 2') and the optoelectronic element (1, 1') is not filled with solder paste (5), and
- contacting of the optoelectronic element (1, 1') to the bond pad (2.2, 2.2') via a bonding wire (3, 3').

8. Method for the production of an optoelectronic arrangement according to claim 8, the optoelectronic element (1, 1') being a photoelement, by means of which light can be converted into electrical signals.

9. Method for the production of an optoelectronic arrangement according to claim 8 or 9, an optical determination of the position of the optoelectronic element (1, 1') being undertaken, before contacting of the optoelectronic element (1, 1') to the bond pad (2.2, 2.2') via a bonding wire (3, 3'), for exact positioning of the bonding wire (3, 3').

10. Method for the production of an optoelectronic arrangement according to claim 8, 9 or 10, the solder paste (4) being applied in such a manner that the latter is distributed on a plurality of deposit points on the surface of the ground pad (2.1, 2.1').

## Revendications

1. Agencement optoélectronique constitué de
- une plaque de circuit imprimé (2, 2') avec un plot de masse (2.1, 2.1') et avec un plot de connexion (2.2, 2.2')
- un élément optoélectronique (1, 1'),
l'élément optoélectronique (1, 1') étant mis en contact électrique avec le plot de connexion (2.2, 2.2') par l'intermédiaire d'un fil de connexion (3, 3') et étant fixé au plot de masse (2.1, 2.1') au moyen d'une liaison brasée, le plot de masse (2.1, 2.1') étant conçu de façon qu'une partie (V) de l'intervalle entre la plaque de circuit imprimé (2, 2') et l'élément optoélectronique (1, 1') ne soit pas remplie de métal de brasage (5),
**caractérisée en ce que** le plot de masse (2.1, 2.1') est conçu de manière symétrique en forme de H.

2. Agencement optoélectronique selon la revendication 1, **caractérisé en ce que** l'élément optoélectronique. (1, 1') est un photoélément par l'intermédiaire duquel de la lumière est convertie en signaux électriques.

3. Agencement optoélectronique selon la revendication 1 ou 2, **caractérisé en ce que** l'intervalle au bord de la surface de l'élément optoélectronique (1,1') tournée vers la plaque de circuit imprimé (2, 2') est rempli en majeure partie de métal de brasage (5).

4. Agencement optoélectronique selon une des revendications précédentes, **caractérisé en ce que** l'élément optoélectronique (1, 1') présente une surface de base rectangulaire, et **en ce que** les grands côtés (1.11) de la surface de base rectangulaire de l'élément optoélectronique (1, 1') sont parallèles aux branches (2.11) du plot de masse en forme de H (2.1, 2.1').

5. Agencement optoélectronique selon la revendication 2, **caractérisé en ce que** le photoélément est fixé au plot de masse (2.1, 2.1') de manière électriquement conductrice au moyen de la liaison brasée, et **en ce qu'**une piste conductrice 2.3 aboutit au plot de masse (2.1) pour prélever les signaux électriques.

6. Agencement optoélectronique selon la revendication 2, **caractérisé en ce que** le photoélément est fixé au plot de masse (2.1, 2.1') de manière électriquement conductrice au moyen de la liaison brasée, et **en ce qu'**une connexion traversant la plaque de circuit imprimé aboutit au plot de masse 2.1 pour prélever les signaux électriques.

7. Procédé de fabrication d'un agencement optoélectronique comportant les étapes suivantes :
- fourniture d'une plaque de circuit imprimé (2, 2') avec un plot de masse (2.1, 2.1') et avec un plot de connexion (2.2, 2.2'), le plot de masse (2.1, 2.1') étant conçu de manière symétrique en forme de H,
- application de pâte à braser (4) sur le plot de masse (2.1, 2.1'),
- mise en place d'un élément optoélectronique (1, 1') sur le plot de masse (2.1, 2.1'),
- fusion de la pâte à braser (4) et refroidissement consécutif, de façon à fixer l'élément optoélectronique (1, 1') au plot de masse (2.1, 2.1') au moyen d'une liaison brasée, le plot de masse (2.1, 2.1') étant conçu de façon qu'une partie (V) de l'intervalle entre la plaque de circuit imprimé (2, 2') et l'élément optoélectronique (1, 1') ne soit pas remplie de métal de brasage (5), et
- mise en contact de l'élément optoélectronique (1, 1') avec le plot de connexion (2.2, 2.2') par l'intermédiaire d'un fil de connexion (3, 3').

8. Procédé de fabrication d'un agencement optoélectronique selon la revendication 8, l'élément optoélectronique (1, 1') étant un photoélément par l'intermédiaire duquel de la lumière peut être convertie en signaux électriques.

9. Procédé de fabrication d'un agencement optoélectronique selon la revendication 8 ou 9, une mesure optique de la position de l'élément optoélectronique (1, 1') étant réalisée avant la mise en contact de l'élément optoélectronique (1, 1') avec le plot de connexion (2.2, 2.2') par l'intermédiaire d'un fil de connexion (3, 3') afin de positionner le fil de connexion (3, 3') avec précision.

10. Procédé de fabrication d'un agencement optoélectronique selon la revendication 8, 9 ou 10, la pâte à braser (4) étant appliquée de façon à être répartie en plusieurs dépôts à la surface du plot de masse (2.1, 2.1').
